# EUROPÄISCHE PATENTSCHRIFT

(11) **EP 2 311 104 B1**
(45) Veröffentlichungstag und Bekanntmachung des Hinweises auf die Patenterteilung: **28.03.2018**
(21) Anmeldenummer: 08875141.7
(22) Anmeldetag: 11.08.2008
(51) Int. Cl.: H01L 33/50

(54) **KONVERSIONS-LED**
CONVERSION LED
DEL À CONVERSION

(43) Veröffentlichungstag der Anmeldung: 20.04.2011
(73) Patentinhaber: OSRAM GmbH, 80807 München (DE); OSRAM Opto Semiconductors GmbH, 93055 Regensburg (DE)
(72) Erfinder: BERBEN, Dirk, 86399 Bobingen (DE); EISERT, Dominik, 93049 Regensburg (DE)
(74) Vertreter: Epping - Hermann - Fischer
(86) Internationale Anmeldenummer: PCT/EP2008/060515
(87) Internationale Veröffentlichungsnummer: WO 2010/017831

(56) Entgegenhaltungen:
- WO-A-03/023857
- WO-A-2006/111907
- WO-A-2007/148253
- DE-A1-102007 001 706
- US-A1- 2006 226 759
- US-A1- 2007 215 890
- US-A1- 2008 116 467
- US-A1- 2008 122 343

## Beschreibung

### Technisches Gebiet

Die Erfindung geht aus von einer Konversions-LED gemäß dem Oberbegriff des Anspruchs 1. Derartige Leuchtstoffe sind insbesondere für die Anwendung bei weißen LEDs gedacht.

### Stand der Technik

Die WO2006114077 zeigt eine Konversions-LED, bei der die Konverter mittels Siebdruck auf den Chip aufgebracht werden. Ähnliches ist in WO2007140766 zu finden.

US 2008/116467 A1 (MUELLER GERD O [US] ET AL; 22. Mai 2008) beschreibt eine Konversions-LED gemäß dem Oberbegriff des Anspruchs 1.

WO 2007/148253 A (PHILIPS INTELLECTUAL PROPERTY [DE]; KONINKL PHILIPS ELECTRONICS NV [NL; 27. Dezember 2007) offenbart eine Konversions-LED mit mehreren Schichten kugelförmiger keramischer Konverterpartikel.

WO 03/023857 A (LUCEA AG [CH]; STAUFERT GERHARD [CH]; 20. März 2003) offenbart ein LED-Array auf einer Trägerplatte, auf die eine Abdeckschicht mit Fresnel-Linsen mittels einer Klebstoffschicht aufgebracht ist, wobei die Klebstoffschicht mit Abstandskugeln versetzt ist. Gegenwärtig werden große Anstrengungen unternommen, keramische Konverter für Konversions-LED einzusetzen. Die genaue Positionierung der Konverter auf dem LED-Chip beeinflusst dabei die Reproduzierbarkeit der optischen Eigenschaften der LED. Die laterale Position eines Konverterelements auf einem LED-Chip kann über Kameras relativ einfach erfasst werden und zur Positionierungskontrolle verwendet werden.

Die vertikale Position, also der Abstand zwischen Chip und Konverter, ist erheblich schwerer zu kontrollieren. Die bisher verwendeten Verfahren wie Siebdruck weisen erhebliche Dickenschwankungen auf, die die Farbortstreuung im Rahmen von Mehrleuchtstoffsystemen stark erhöhen. An sich sind Systeme mit getrennten Schichten verschiedenartiger Leuchtstoffe schon bekannt, siehe beispielsweise EP 1 480 278 oder US 2004/173806. Dort ist auch bereits der längerwellige Leuchtstoff näher als der kürzerwellige Leuchtstoff am Chip platziert. Jedoch ist das Problem der Dickenschwankung bisher ignoriert worden, da eine Lösung nicht denkbar schien.

### Darstellung der Erfindung

Die Aufgabe der vorliegenden Erfindung ist es, eine Konversions-LED anzugeben, die ein oder mehrere Leuchtstoffe verwendet, wobei der Abstand zwischen Chip und Konverter präzise definiert ist.

Diese Aufgabe wird gelöst durch die kennzeichnenden Merkmale des Anspruchs 1.

Besonders vorteilhafte Ausgestaltungen finden sich in den abhängigen Ansprüchen.

Die neuartige Konversions-LED bezieht sich insbesondere auf Hybrid-Anwendungen. Dabei hat es sich als sinnvoll erwiesen, einen längerwelligen Leuchtstoff, insbesondere einen rot emittierenden Leuchtstoff, näher an dem Chip zu platzieren als einen zweiten kürzerwelligen Leuchtstoff, insbesondere einen gelben oder grünen Leuchtstoff. Der zweite kürzerwellige Leuchtstoff ist dabei bevorzugt ein keramischer Konverter, der als starres Plättchen vorliegt. Er kann ein Leuchtstoff-Glas sein o.ä.. Hier ist ein definierter Abstand besonders wichtig, weil sich die Menge an längerwelligem Leuchtstoff über die Konzentration nur dann einstellen lässt, wenn der Abstand vom Chip zum keramischen Konverter präzise bekannt ist.

Grundsätzlich muss das keramische Plättchen mittels eines Klebers auf dem Chip befestigt werden. Ein möglicher Kleber, der zwischen Chip und Konverter-Plättchen eingebracht wird, ist das als Vergussmasse bekannte Silikon.

In den Kleber kann man den gewünschten längerwelligen Leuchtstoff dispergieren. Ein konkreter längerwelliger Leuchtstoff ist ein rot emittierender Leuchtstoff wie ein Nitrid oder Oxinitrid. Um nun einen definierten Abstand sicherzustellen, bringt man neben dem längerwelligen Leuchtstoff auch Abstandshalter in den Kleber ein. Als Abstandshalter eigenen sich insbesondere Glasperlen mit definierten Eigenschaften, insbesondere einem definierten Durchmesser. Dabei wird eine geringe Menge an Glasperlen in den Kleber eingebracht, die ausreicht, den Abstand zu definieren.

Derartige Glasperlen oder Glaskugeln sind an sich bekannt. Sie werden u.a. als Kalibrierstandards für Partikelgrößen-Messgeräte eingesetzt. Sie sind in Größen von etwa 100 Nanometern bis hin zu einigen zig Mikrometern problemlos erhältlich. Ein Anbieter ist beispielsweise Microparticles. Diese Standard-Glaskugeln zeichnen sich durch äußerst geringe Größenvarianz aus. Außerdem bietet das Material Glas, bevorzugt Hartglas oder SiO2, höchste Alterungsbeständigkeit und chemische Inertheit. Alterungsprobleme sind daher minimal.

Die Herstellung gelingt, indem dispergierte Masse, bestehend aus Vergussmaterial, längerwelligen Leuchtstoff und Abstandshalter, im Überschuss auf den Chip aufgebracht wird. Anschließend wird das keramische Konverter-Plättchen auf die dispergierte Masse aufgepresst, bis der Abstand zwischen dem Plättchen und dem Chip dem Durchmesser der Kugeln entspricht.

Alternativ zu den Glaskugeln kann in anderen Beispielen, die nicht unter die Definition der vorliegenden Erfindung fallen, auch ein bandartiger Abstandshalter verwendet werden, insbesondere ein Rahmen aus einem transparenten oder transluzenten Kunststoff oder dielektrisches Material wie SnO2. Auch Metall ist möglich. Die Wand kann dabei Aussparungen aufweisen, aus denen überschüssiges Material abfließen kann.

Ein solcher Rahmen kann mittels Lithographie oder Layer-Transfer aufgebracht werden. Er kann aus Silikon oder einem strahlungsbeständigen Material wie Teflon bestehen. Er ist jedoch deutlich aufwendiger als die Glaskugeln. Wird ein lichtundurchlässiges Material wie Metall oder POM, Delrin oder Polyimid verwendet, sollte der Rahmen den Leiterbahnen auf der Chip-Oberfläche folgen, um Verluste durch Abschattung zu vermeiden.

Der mit einem Rahmen versehene Chip lässt sich dann mit verschiedenen Methoden mit der gewünschten Leuchtstoff-Paste füllen. Neben Siebdruck ist auch Rakeln (doctorblade), Tauchbad oder air brush etc. verwendbar.

Da auf den Rahmen der keramische Konverter als Plättchen angepresst wird, ist eine Dickenkontrolle der Leuchtstoff-Paste des kürzerwelligen Leuchtstoffs nicht zwingend erforderlich. Eine gewisse Kontrolle ist aber immer vorteilhaft, um die Menge an Paste des kürzerwellige Leuchtstoffs zu minimieren, welche beim Aufbringen des keramischen Plättchens ansonsten seitlich ausgepresst wird.

Ohne präzise Abstandskontrolle ist ein Hybrid-System aus verschiedenartigen Konvertern bei einer Konversions-LED nicht sinnvoll. Die Menge an längerwelligem Leuchtstoff, der zwischen Chip und keramischem Plättchen mit kürzerwelligem Leuchtstoff eingebracht ist, muss zwingend kontrolliert werden.

Außer Kugeln oder einem bandartigen Rahmen können auch andere Abstandshalter verwendet werden. Ein anderes Bespiel sind geätzte Strukturen, in das Konverter-Plättchen integrierte Strukturen wie Zapfen oder Wülste.

### Kurze Beschreibung der Zeichnungen

Im Folgenden soll die Erfindung anhand mehrerer Beispiele näher erläutert werden. Die Figuren zeigen:
- Figur 1: eine Prinzipdarstellung der erfindungsgemäßen Konversions-LED mit Glaskugeln;
- Figur 2: eine Prinzipdarstellung einer Konversions-LED mit einem Rahmen;
- Figur 3: ein Detail des Rahmens;
- Figur 4: ein weiteres Bespiel einer Konversions-LED.

### Bevorzugte Ausführungsform der Erfindung

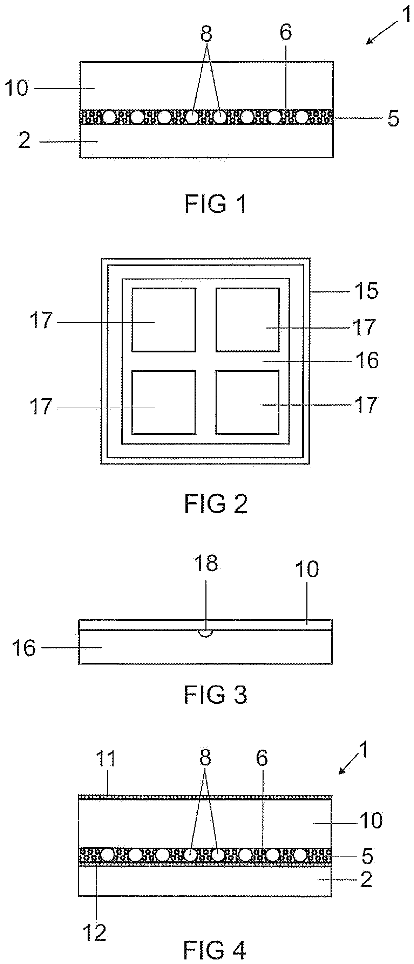

Eine Konversions-LED 1 weist gemäß Figur 1 einen Chip 2 auf, der primäre Strahlung emittiert. In aller Regel ist die primäre Strahlung blau mit einer Peakwellenlänge im Bereich 420 bis 480 nm, bevorzugt 450 bis 470 nm.

Auf dem Chip ist ein Verguss 5 aufgebracht, der den längerwelligen Leuchtstoff 6 als Dispersion enthält. Der längerwellige Leuchtstoff ist in aller Regel ein rot emittierender Leuchtstoff wie er im Stand der Technik angeführt ist, wie beispielsweise ein Nitrid, Oxinitrid und wie in WO 2006/114077 dargelegt. Außer den Leuchtstoff-Partikeln ist im Verguss auch ein Anteil an Glaskugeln 8 mit definiertem Durchmesser, beispielsweise 500 nm, mit geringer Streubreite, enthalten. Über der Schicht aus Vergussmaterial ist eine zweite Schicht angebracht. Diese ist als keramisches Konverter-Plättchen 10 ausgeführt, die einen gelb-grünen Leuchtstoff wie beispielsweise YAG:Ce enthält. Ein derartiger keramischer Konverter ist beispielsweise in US2004145308 offenbart.

Die Konzentration an Glaskugeln muss natürlich so gering gewählt werden, dass eine Mono-Schicht an Glaskugeln 8 locker im Harz der Vergussmasse 5 verteilt ist und nur als Stütze im Sinne von Abstandshaltern fungiert. Ein konkretes Ausführungsbeispiel sind Glaskugeln mit einem Durchmesser von etwa 3 µm.

In Figur 2 ist ein anderes Beispiel gezeigt, bei dem in Draufsicht ein Chip 15 gezeigt ist, der rechteckig geschnitten ist. Auf ihm ist ein Rahmen 16 aufgelegt, der als Abstandshalter fungiert. Er ist mit dem Verguss 17, der den ersten Leuchtstoff enthält, ausgefüllt. Zum Abfließen des überschüssigen Gießharzes sind im Rahmen Durchbrüche 18 vorgesehen, die in der Seitenansicht der Figur 3 erkennbar sind. Auf dem Rahmen 16 sitzt wieder das Plättchen 10, das den kürzerwelligen keramischen Konverter enthält.

Selbstverständlich kann dieses Plättchen nicht nur ein rechteckig gestalteter Block sein, sondern beispielsweise auch als Linse geformt sein, deren Unterseite plan ist, und deren Oberseite konvex gewölbt ist. Dabei ist der Leuchtstoff aber trotzdem homogen in einer Schicht gleicher Dicke enthalten.

In Figur 4 ist ein Bespiel mit einer UV-LED 1 gezeigt, wobei in der Regel ein Chip 2 verwendet wird mit einer primären Strahlung im Bereich 300 bis 420 nm, bevorzugt 360 bis 400 nm. In diesem Falle einer UV-LED ist die zweite Schicht 10 mit dem kürzerwelligen Leuchtstoff, verglichen mit der ersten Schicht, noch von einer weiteren, dritten Schicht mit einem noch kürzerwelligen Leuchtstoff, hier einem blauen Leuchtstoff, als Verguss 11 gefolgt sein. Es ist aber alternativ oder additiv auch möglich, dass die primäre Strahlung der UV-LED zunächst erst einmal vollständig in blaue Strahlung mit Hilfe eines direkt dem Chip vorgeschalteten Konverters 12, hier als Dünnschicht-Konverter eingezeichnet, umgewandelt wird.

Der Begriff erster Leuchtstoff umfasst allgemein auch die Möglichkeit, dass dieser eine Mischung aus mehreren Leuchtstoffen ist. Der Begriff zweiter Leuchtstoff umfasst ebenfalls die Möglichkeit, dass dieser eine Mischung aus mehreren Leuchtstoffen ist. Beispielsweise kann eine Mischung mehrerer Rot-Leuchtstoffe mit unterschiedlicher Peakwellenlänge verwendet werden oder eine Mischung eines Rotleuchtstoffs und eines orangen Leuchtstoffs.

## Patentansprüche

1. Konversions-LED (1) mit einem Chip (2), auf dem eine erste, einen Leuchtstoff (6) enthaltende Schicht (5) aufgebracht ist, wobei auf dieser ersten Schicht (5) eine zweite, einen zweiten Leuchtstoff enthaltende Schicht (10) aufgebracht ist, wobei die erste Schicht (5) eine Vergussmasse ist, in der der erste Leuchtstoff (6) dispergiert ist, und die zweite Schicht (10) ein Festkörper in Form eines starren Plättchens ist,
**dadurch gekennzeichnet, dass**
die erste Schicht (5) mit einem Abstandshalter ausgestattet ist, wobei der Abstandshalter durch Kugeln (8) mit vorgegebenem Durchmesser realisiert ist und der Abstand zwischen dem Plättchen (10) und dem Chip (2) dem Durchmesser der Kugeln (8) entspricht.

2. Konversions-LED nach Anspruch 1, wobei der erste Leuchtstoff (6) längerwellig emittiert als der zweite Leuchtstoff.

3. Konversions-LED nach Anspruch 2, wobei der erste Leuchtstoff (6) rot emittiert, wobei die Peakwellenlänge insbesondere im Bereich 580 nm bis 680 nm liegt.

4. Konversions-LED nach Anspruch 2, wobei der zweite Leuchtstoff im Grünen bis Gelben emittiert, wobei die Peakwellenlänge insbesondere im Bereich 480 nm bis 560 nm liegt.

5. Konversions-LED nach Anspruch 1, wobei die Vergussmasse (5) Silikon ist.

6. Konversions-LED nach Anspruch 1, wobei die Kugeln (8) aus Glas gefertigt sind.

7. Konversions-LED nach Anspruch 1, wobei die Kugeln (8) einen Durchmesser aus dem Wertebereich von 150 nm bis 25 µm besitzen.

8. Konversions-LED nach Anspruch 1, wobei die zweite Schicht (10) ein keramischer Konverter ist.

9. Konversions-LED nach Anspruch 1, wobei der Chip (2) primäre Strahlung im Bereich UV bis blau, insbesondere im Bereich 300 nm bis 480 nm, emittiert, wobei ggf.
noch ein dritter Leuchtstoff verwendet wird.

## Claims

1. A conversion LED (1) comprising a chip (2) on which a first layer (5) containing a fluorescent substance (6) is deposited, wherein on this first layer (5) a second layer (10) containing a second fluorescent substance is deposited, wherein the first layer (5) is a potting material in which the first fluorescent substance (6) is dispersed, and the second layer (10) is a solid in the form of a rigid plate,
**characterized in that**
the first layer (5) being provided with a spacer, wherein the spacer is realized by balls (8) with a predefined diameter and the distance between the plate (10) and the chip (2) corresponds to the diameter of the balls (8).

2. Conversion LED according to claim 1,
wherein the first fluorescent substance (6) emit at longer wavelength than the second fluorescent substance.

3. Conversion LED according to claim 2,
wherein the first fluorescent substance (6) emits red, wherein the peak wavelength particularly being in the range 580 nm to 680 nm.

4. Conversion LED according to claim 2,
wherein the second fluorescent substance emits in the green to yellow region, the peak wavelength particularly being in the range 480 nm to 560 nm.

5. Conversion LED according to claim 1,
wherein the potting material (5) is silicone.

6. Conversion LED according to claim 1,
wherein the balls (8) are made of glass.

7. Conversion LED according to claim 1,
wherein the balls (8) have a diameter of the range from 150 nm to 25 µm.

8. Conversion LED according to claim 1,
wherein the second layer (10) is a ceramic converter.

9. Conversion LED according to claim 1,
wherein the chip (2) emits primary radiation in the UV to blue region, in particular in the region 300 nm to 480 nm, wherein a third fluorescent substance is used, if applicable.

## Revendications

1. LED de conversion (1) comprenant une puce (2) sur laquelle est appliquée une première couche (5) contenant un matériau fluorescent (6), une deuxième couche (10) contenant un deuxième matériau fluorescent étant appliquée sur cette première couche (5), la première couche (5) étant une masse de scellement dans laquelle le premier matériau fluorescent (6) est dispersé, et la deuxième couche (10) étant un corps solide sous forme d'une plaquette rigide,
**caractérisée en ce que**
la première couche (5) est équipée d'un écarteur, l'écarteur étant réalisé par des billes (8) ayant un diamètre prédéfini et l'écart entre la plaquette (10) et la puce (2) correspondant au diamètre des billes (8).

2. LED de conversion selon la revendication 1, le premier matériau fluorescent (6) émettant avec une plus grande longueur d'onde que le deuxième matériau fluorescent.

3. LED de conversion selon la revendication 2, le premier matériau fluorescent (6) émettant en rouge, la longueur d'onde de pic étant notamment située dans la plage de 580 nm à 680 nm.

4. LED de conversion selon la revendication 2, le deuxième matériau fluorescent émettant en vert jusqu'au jaune, la longueur d'onde de pic étant notamment située dans la plage de 480 nm à 560 nm.

5. LED de conversion selon la revendication 1, la masse de scellement étant de la silicone.

6. LED de conversion selon la revendication 1, les billes (8) étant fabriquées en verre.

7. LED de conversion selon la revendication 1, les billes (8) ayant un diamètre situé dans la plage des valeurs de 150 nm à 25 µm.

8. LED de conversion selon la revendication 1, la deuxième couche (10) étant un convertisseur céramique.

9. LED de conversion selon la revendication 1, la puce (2) émettant un rayonnement primaire dans la plage ultraviolet jusqu'au bleu, notamment dans la plage de 300 nm à 480 nm, un troisième matériau fluorescent étant éventuellement utilisé.
